# EUROPÄISCHE PATENTSCHRIFT

(11) **EP 3 580 788 B1**
(45) Veröffentlichungstag und Bekanntmachung des Hinweises auf die Patenterteilung: **16.12.2020**
(21) Anmeldenummer: 18705362.4
(22) Anmeldetag: 09.02.2018
(51) Int. Cl.: H01L 35/22, H01L 35/26

(54) **THERMOELEKTRISCHES ELEMENT, THERMOELEKTRISCHER GENERATOR, PELTIER ELEMENT UND VERFAHREN ZUR HERSTELLUNG EINES THERMOELEKTRISCHEN ELEMENTS**
THERMOELECTRIC ELEMENT, THERMOELECTRIC GENERATOR, PELTIER ELEMENT, AND METHOD FOR PRODUCING A THERMOELECTRIC ELEMENT
ÉLÉMENT THERMOÉLECTRIQUE, GÉNÉRATEUR THERMOÉLECTRIQUE, ÉLÉMENT PELTIER ET PROCÉDÉ DE FABRICATION D'UN ÉLÉMENT THERMOÉLECTRIQUE

(30) Priorität: 10.02.2017 DE 102017102703
(43) Veröffentlichungstag der Anmeldung: 18.12.2019
(73) Patentinhaber: Universität Duisburg-Essen, 45141 Essen (DE)
(72) Erfinder: PENTCHEVA, Rossitza, 47053 Duisburg (DE); GEISLER, Benjamin, 45472 Mülheim an der Ruhr (DE)
(74) Vertreter: Gulde & Partner
(86) Internationale Anmeldenummer: PCT/EP2018/053322
(87) Internationale Veröffentlichungsnummer: WO 2018/146269

(56) Entgegenhaltungen:
- US-A- 5 900 071
- US-A1- 2008 178 920
- US-A1- 2014 318 592
- BENJAMIN GEISLER ET AL: "Design of n-and p-type oxide thermoelectrics in LaNiO 3 /SrTiO 3 (001) superlattices exploiting interface polarity", PHYSICAL REVIEW B, Bd. 95, 2. März 2017 (2017-03-02), Seite 125301, XP055467116, DOI: 10.1103/PhysRevB.95.125301
- MYUNG JOON HAN ET AL: "Fermi level density of states modulation without charge transfer in nickelate superlattices", JOURNAL OF PHYSICS: CONDENSED MATTER, INSTITUTE OF PHYSICS PUBLISHING, BRISTOL, GB, Bd. 26, Nr. 14, 18. März 2014 (2014-03-18) , Seite 145501, XP020260080, ISSN: 0953-8984, DOI: 10.1088/0953-8984/26/14/145501 [gefunden am 2014-03-18]

## Beschreibung

Die Erfindung betrifft ein thermoelektrisches Element, einen thermoelektrischen Generator und ein Peltier-Element, welche das thermoelektrische Element aufweisen, sowie ein Verfahren zur Herstellung eines thermoelektrischen Elements.

### Technologischer Hintergrund

Thermoelektrische Generatoren können Abwärme in elektrische Energie konvertieren, wodurch vorteilhaft eine Energierückgewinnung erzielt werden kann. Thermoelektrische Generatoren umfassen dabei üblicherweise zwei verschiedene Materialien, wobei eines der Materialien ein sogenanntes p-Typ-Thermoelektrikum und das andere Material ein sogenanntes n-Typ-Thermoelektrikum darstellt. Hierbei steht das p-Typ-Thermoelektrikum (n-Typ-Thermoelektrikum) für ein Material mit einem positiven (negativen) thermoelektrischen Antwortkoeffizienten, auch Seebeck-Koeffizient genannt. Die beiden unterschiedlichen Materialien sind dabei häufig strukturell und chemisch unterschiedlich und daher nicht in optimaler Weise kompatibel.

Eine Möglichkeit die Kompatibilität von p- und n-Typ-Thermoelektrika zu verbessern ist, sich auf ein einziges Material für die beiden Thermoelektrika zu beschränken, beispielsweise einen Halbleiter wie Silizium oder Germanium, und die Materialien dann entsprechend mit Fremdatomen zu dotieren, so dass sich der gewünschte thermoelektrische Effekt einstellt. Ein Nachteil dieses Vorgehens liegt in der statistischen Natur der Dotierung. Darüber hinaus kommt es bei höheren Temperaturen zu einer Migration und Segregation der Dotieratome, was die Auslöschung ihrer Wirkung zufolge haben kann.

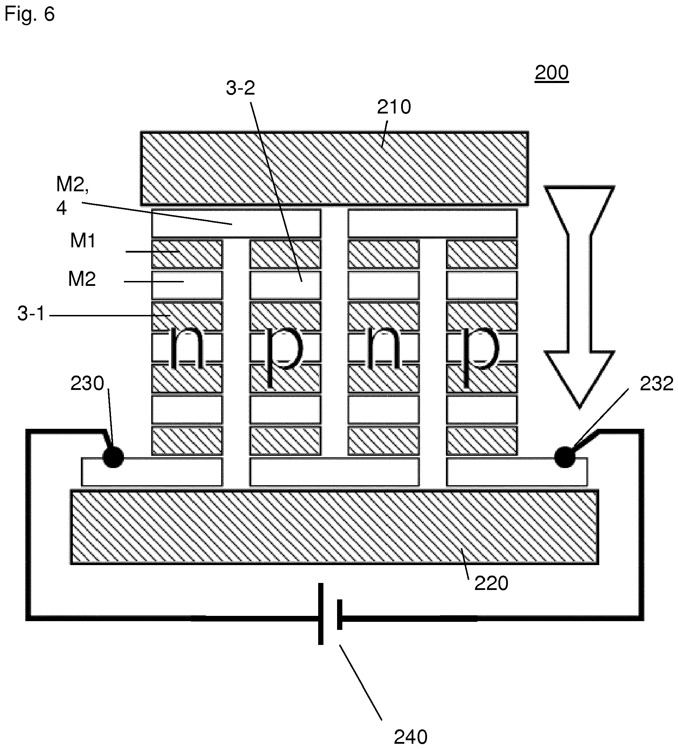

Alternativ dazu konnten in einer theoretischen Arbeit aus der Stapelung von alternierenden zweidimensionalen Elektronen- und Lochgasen Übergitter geformt werden, bei denen sich p-Typ Grenzflächen mit n-Typ Grenzflächen in Stapelrichtung des Übergitters jeweils abwechseln (A.S. Botana et al., "All-3d electron-hole bilayers in CrN/MgO(111) multilayers for thermoelectric applications", Phys. Rev. Applied 7 (2017), Art. Nr. 024002). Verbindet man dann aufeinanderfolgende Grenzschichten in Stapelrichtung jeweils vertikal an alternierenden Rändern des Übergitters, so kann, bei Anliegen eines Temperaturgradienten senkrecht zur Stapelrichtung, infolge des thermoelektrischen Koeffizienten eine Spannung in Stapelrichtung abgegriffen werden. Dies impliziert umgekehrt, dass sich bei Anlegen einer Spannung ein Temperaturgradient senkrecht zur Spannung und senkrecht zur Stapelrichtung ausbildet. Problematisch ist, dass dieses Konzept nur dann funktioniert, wenn man hochpräzise, d.h. auf der Längenskala weniger Atome, die p-Typ und n-Typ Grenzflächen leitend in Stapelrichtung und abwechselnd an gegenüberliegenden Seiten des Übergitters verbindet, wie in oben genannter Arbeit (A.S. Botana et al., FIG. 6) schematisch dargestellt. Ansonsten kommt es zur Kompensation von positivem und negativem Seebeck-Koeffizienten. Zudem darf die Struktur der in diesem Beispiel beteiligten zweidimensionalen Elektronen- bzw. Lochgase durch die Verbindung nicht gestört werden.

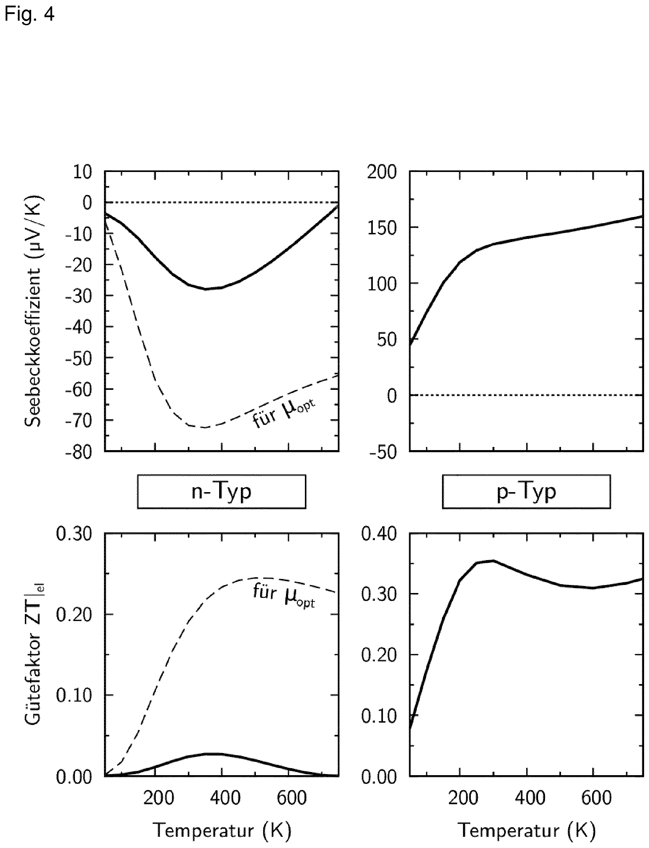

US 2014/318592 A1 (SZTEIN ALEXANDER [US] ET AL) 30. Oktober 2014 (2014-10-30) offenbart ein thermoelektrisches Element umfassend: eine n-Typ Übergitterstruktur umfassend sich abwechselnde Schichten aus einem ersten Material (GaN) und einem davon verschiedenen, zweiten Material (InAlN), wobei zwischen den sich jeweils abwechselnden Schichten polare Grenzflächen (interfaces) mit Elektronenüberschuss ausgebildet sind. US 2008/178920 A1 (ULLO JOHN [US]) 31. Juli 2008 (2008-07-31) offenbart ein Peltier-Element umfassend: eine Wärmequelle, eine Wärmesenke, und ein zwischen Wärmequelle und Wärmesenke angeordnetes thermoelektrisches Element (Superlattices, Fig 4), wobei das thermoelektrisches Element zwei Kontakte zum Anschließen einer Energiequelle aufweist.

Im Besonderen besteht somit ein Bedarf nach temperaturstabilen p-Typ thermoelektrischen Elementen und n-Typ thermoelektrischen Elementen, die strukturell und elektronisch miteinander kompatibel sind.

### Zusammenfassung der Erfindung

Erfindungsgemäß wird ein thermoelektrisches Element zur Verfügung gestellt, umfassend eine n-Typ Übergitterstruktur bestehend aus sich abwechselnden Schichten aus einem ersten Material und einem davon verschiedenen, zweiten Material, wobei zwischen den sich jeweils abwechselnden Schichten polare Grenzflächen mit Elektronenüberschuss ausgebildet sind sowie eine p-Typ Übergitterstruktur von sich abwechselnden Schichten aus dem ersten Material und dem davon verschiedenen, zweiten Material, wobei zwischen den sich jeweils abwechselnden Schichten polare Grenzflächen mit Lochüberschuss ausgebildet sind. Die n-Typ Übergitterstruktur und die p-Typ Übergitterstruktur weisen dabei eine physische Verbindung bzw. einen physischen Kontakt auf.

Mit anderen Worten weist die n-Typ Übergitterstruktur jeweils allein n-Typ Grenzflächen zwischen den Schichten auf und die p-Typ Übergitterstruktur jeweils allein p-Typ Grenzflächen. Dies erfolgt ohne Dotierung, also keine gezielte Einbringung von Fremdatomen auf. Die n-Typ Übergitterstruktur ist bevorzugt räumlich getrennt von der p-Typ Übergitterstruktur angeordnet und beide Übergitterstrukturen werden allein durch eine Verbindung, bevorzugt eine einzige Verbindung, miteinander verbunden. Besonders bevorzugt sind die beiden Übergitterstrukturen räumlich getrennt und parallel voneinander angeordnet. Es werden also zwei Übergitterstrukturen mit verschiedener Polarität miteinander gekoppelt. Vorteilhafterweise können solche separaten n- und p-Typ Übergitterstrukturen technisch einfacher als Übergitterstrukturen mit sich abwechselnden n- und p-Typ Grenzflächen gehandhabt werden.

Ein Übergitter (engl. superlattice) bezeichnet allgemein eine Festkörperheterostruktur, die aus einer Abfolge von dünnen Schichten zweier unterschiedlicher Materialien besteht, die sich periodisch wiederholen. Parallel zu den Grenzflächen sind die quantenmechanischen Wellenfunktionen normale Bloch-Funktionen, während senkrecht dazu Quantisierungseffekte eines Quantentopfes auftreten.

Dabei sind erfindungsgemäß die jeweiligen übereinandergestapelten Schichten nur wenige Monolagen bzw. atomare Lagen dick. Die Schichten können eine Dicke von 1-10 nm aufweisen, bevorzugter von 1-5 nm, noch bevorzugter von 1-2 nm. Solche geringe Schichtdicken gewährleisten den Transport durch Tunneln senkrecht zu den Grenzflächen.

Aufgrund der Ausbildung der n-Typ Übergitterstruktur und der p-Typ Übergitterstruktur aus Abfolgen von Schichten, die aus denselben ersten und zweiten Materialien bestehen, sind die erfindungsgemäßen Übergitterstrukturen strukturell und chemisch kompatibel. Über die Verbindung bildet sich bei Anlegen eines Temperaturgradienten an den beiden Übergitterstrukturen eine Spannung an dem thermoelektrischen Element aus.

Die Spannung bildet sich, bei Anliegen eines Temperaturgradienten in Stapelrichtung, senkrecht zu den Schichten der Übergitterstrukturen aus, also ebenfalls in Stapelrichtung. Umgekehrt bildet sich der Temperaturgradient parallel zu einer angelegten Spannung aus. Erfindungsgemäß wird der Elektronentransport senkrecht zu den Schichten ausgenutzt, also in Stapelrichtung. Vorteilhafterweise kann dabei das Prinzip der Phononenstreuung, welche die unerwünschte thermische Gitterleitfähigkeit absenkt, ausgenutzt werden. Es wird kein Elektronentransport parallel zu den Schichten, also in den zweidimensionalen Elektronen- und Lochgasen, ausgenutzt.

Die erfindungsgemäße p-Typ Übergitterstruktur weist einen positiven thermoelektrischen Antwortkoeffizienten auf, der auch als Seebeck-Koeffizient bezeichnet wird. Entsprechend weist eine erfindungsgemäße n-Typ Übergitterstruktur einen negativen thermoelektrischen Antwortkoeffizienten auf. Eine n-Typ Grenzfläche ist dabei eine Grenzfläche mit Elektronenüberschuss, die räumlich in einer oder wenigen Schichten lokalisiert ist. Analog ist eine p-Typ Grenzfläche eine mit Löchern angereicherte Grenzfläche. Durch eine gezielte unterschiedliche Terminierung der Schichten aus erstem und zweitem Material an der Grenzfläche ergibt sich gezielt eine positive oder eine negative Polarität.

Jede einzelne der beiden Übergitterstrukturen für sich bildet dabei ein n-Typ bzw. p-Typ Thermoelektrikum aus. Dieser Begriff wird im Folgenden synonym für die Übergitterstruktur verwendet.

Die beiden Übergitterstrukturen bestehen erfindungsgemäß aus denselben zwei Materialien, ohne Dotierung mit Fremdatomen. Sie unterscheiden sich lediglich durch die Terminierung der Schichten aus erstem bzw. zweitem Material, also durch die Stapelfolge der Atome aus dem ersten bzw. dem zweiten Material an den Grenzflächen. Dies verbessert vorteilhafterweise die Kompatibilität der beiden Thermoelektrika.

Somit kann allein durch gezielte Variation des Grenzflächentyps bzw. des Überschusses von Löchern oder Elektronen in den polaren Grenzflächen sowohl ein p-Typ-Thermoelektrikum als auch ein n-Typ-Thermoelektrikum ausgebildet werden, die vorteilhaft strukturell und elektronisch miteinander kompatibel sind, da diese sich nur in den jeweiligen Grenzflächen unterscheiden. Dadurch eignen sich diese Thermoelektrika besonders für den Einsatz in einem thermoelektrischen Generator. Dies erfolgt ohne Dotierung, also keine gezielte Einbringung von Fremdatomen auf.

Die polaren Grenzflächen mit Lochüberschuss unterscheiden sich von den polaren Grenzflächen mit Elektronenüberschuss am Übergang zwischen einer Schicht aus erstem Material und zweitem Material durch die gezielte Stapelfolge der Atome aus dem ersten bzw. dem zweiten Material an der Grenzfläche. Somit kann allein durch die Stapelfolge der Atome aus dem ersten bzw. dem zweiten Material ohne Dotierung am Übergang zwischen erster und zweiter Schicht eingestellt werden, ob es sich um ein n-Typ oder ein p-Typ Thermoelektrikum handelt. Die polaren Grenzflächen mit Lochüberschuss unterscheiden sich also von den polaren Grenzflächen mit Elektronenüberschuss im Bereich des Übergangs zwischen einer Schicht aus erstem Material und zweitem Material dadurch, dass die Schichten so terminiert sind, dass ein Elektronenüberschuss bzw. ein Lochüberschuss in der polaren Grenzfläche vorhanden ist.

Bevorzugt weisen die jeweiligen p-Typ/n-Typ Grenzflächen eine geringe Polaritätsdifferenz auf, bevorzugt mit Ladungen 1+/1-. Im Vergleich zu Grenzflächen mit hoher Polaritätsdifferenz (z.B. 3+/2-) weisen Grenzflächen mit niedriger Polaritätsdifferenz eine geringe Anfälligkeit für die Bildung kompensierender Defekte auf.

Vorteilhafterweise wird eine Dotierung der Materialien mit Fremdatomen folglich nicht benötigt. Sie kann jedoch zusätzlich erfolgen.

Mindestens eines der beiden ersten und zweiten Materialien ist ein Isolator, bevorzugt ein oxidbasierter Isolator.

Eines der beiden ersten und zweiten Materialien ist bevorzugt ein oxidbasiertes Metall oder ein oxidbasierter Isolator und das andere der beiden ersten und zweiten Materialien ist ein oxidbasierter Isolator. Oxide sind thermisch stabiler als dotierte Halbleitermaterialien und können auf atomarer Längenskala mit scharfen, wohldefinierten Grenzflächen gewachsen werden.

In einem bevorzugten Ausführungsbeispiel weisen sowohl erstes als auch zweites Material jeweils eine Perowskit-Struktur auf. Diese ist besonders thermisch stabil.

Das erste und das zweite Material können in einem bevorzugten Ausführungsbeispiel der chemischen Formel ABO₃ folgen. Die polare Grenzfläche mit Elektronenüberschuss ist dann eine (A O)⁺/(B'O₂)⁰ Grenzfläche und die polare Grenzfläche mit Lochüberschuss eine (A'O)⁰/(BO₂)⁻ Grenzfläche.

Das erste Material kann LaNiO₃ und das zweite Material kann SrTiO₃ sein.

Polare Grenzflächen mit Elektronenüberschuss können die Abfolge (LaO)⁺/(TiO₂)⁰ und polare Grenzflächen mit Lochüberschuss die Abfolge (NiO₂)⁻/(SrO)⁰ aufweisen.

Mit anderen Worten kann das erste oxidbasierte Material bevorzugt mit der chemischen Formel ABO₃ in der Perowskit-Struktur ausgebildet sein und/oder das zweite oxidbasierte Material kann bevorzugt mit der chemischen Formel (A')(B')O₃ in der Perowskit-Struktur ausgebildet sein, wobei die Kristallrichtung der [001]-Kristallrichtung entspricht. Dabei kann A=La und B=Ni und/oder A'=Sr und B'=Ti sein, wobei die n-Typ-Grenzfläche durch die polare elektronengeladene Grenzfläche (LaO)⁺/(TiO₂)⁰ und/oder die p-Typ-Grenzfläche durch die polare Grenzfläche (NiO₂)⁻/(SrO)⁰ ausgebildet ist, wobei die Kristallrichtung in dem spezifischem, nicht beschränkendem Ausführungsbeispiel der [001]-Kristallrichtung entspricht.

Das Thermoelektrikum bildet bevorzugt eine erste Stapelfolge mit der Stöchiometrie (LaNiO₃)_{3,5}/(SrTiO₃)_{2,5} in [001]-Kristallrichtung und/oder eine zweite Stapelfolge mit der Stöchiometrie (LaNiO₃)_{2,5}/(SrTiO₃)_{3,5} in [001]-Kristallrichtung aus.

In einem weiteren Ausführungsbeispiel können das erste Material ein erster nicht-oxidischer Halbleiter und das zweite Material ein zweiter, davon verschiedener nicht-oxidischer Halbleiter sein. Vorteilhafterweise können somit Halbleiter ohne Dotierung mit Fremdatomen zur Ausbildung eines thermoelektrischen Elementes verwendet werden.

Ferner wird ein thermoelektrischer Generator vorgeschlagen, umfassend eine Wärmequelle, eine Wärmesenke, und ein zwischen Wärmequelle und Wärmesenke angeordnetes erfindungsgemäßes thermoelektrisches Element, wobei das thermoelektrische Element zwei Kontakte zum Anschließen einer Last aufweist.

Der thermoelektrische Generator weist vorteilhaft p-Typ-Thermoelektrika und n-Typ-Thermoelektrika mit hoher elektronischer und struktureller Kompatibilität auf, da diese sich lediglich durch die Polarität des Grenzflächentyps unterscheiden.

Jeweils eine erste Seite der n-Typ Übergitterstruktur und der p-Typ Übergitterstruktur können mit der Wärmequelle verbunden sein und eine gegenüberliegende Seite der n-Typ Übergitterstruktur und der p-Typ Übergitterstruktur können mit der Wärmesenke verbunden sein.

In einem bevorzugten Ausführungsbeispiel können weitere thermoelektrische Elemente zwischen Wärmequelle und Wärmesenke in alternierender Reihenschaltung angeordnet sein.

Des Weiteren wird entsprechend dem thermoelektrischen Generator ein Peltier-Element vorgeschlagen umfassend eine Wärmequelle, eine Wärmesenke, und ein zwischen Wärmequelle und Wärmesenke angeordnetes erfindungsgemäßes thermoelektrisches Element, wobei das thermoelektrische Element zwei Kontakte zum Anschließen einer Energiequelle aufweist.

Jeweils eine erste Seite der n-Typ Übergitterstruktur und der p-Typ Übergitterstruktur können mit der Wärmequelle verbunden sein und eine gegenüberliegende Seite der n-Typ Übergitterstruktur und der p-Typ Übergitterstruktur können mit der Wärmesenke verbunden sein.

In einem bevorzugten Ausführungsbeispiel können weitere thermoelektrische Elemente zwischen Wärmequelle und Wärmesenke in alternierender Reihenschaltung angeordnet sein.

Zudem wird ein Verfahren zur Herstellung von thermoelektrischen Elementen vorgeschlagen, umfassend die Schritte des Ausbildens einer n-Typ Übergitterstruktur durch alternierendes Stapeln von Schichten aus einem ersten Material und einem zweiten, vom ersten Material verschiedenen Material, welche gezielt mit einer n-Typ Grenzfläche ausgebildet sind, und des Ausbildens einer p-Typ Übergitterstruktur durch alternierendes Stapeln von Schichten aus dem ersten Material und dem zweiten, vom ersten Material verschiedenen Material, welche gezielt mit einer p-Typ Grenzfläche ausgebildet sind, sowie des Verbindens der n-Typ Übergitterstruktur und der p-Typ Übergitterstruktur.

Ferner wird ein Verfahren zur Herstellung von thermoelektrischen Elementen vorgeschlagen, umfassend die Schritte des Ausbildens einer n-Typ Übergitterstruktur durch alternierendes Stapeln von Schichten aus einem ersten Material mit der chemischen Formel ABO₃ und einem zweiten, vom ersten Material verschiedenen Material mit der chemischen Formel A'B'O₃, welche gezielt an der Grenzfläche eine Stapelfolge AO/B'O₂ aufweisen, und des Ausbildens einer p-Typ Übergitterstruktur durch alternierendes Stapeln von Schichten aus dem ersten Material und dem zweiten, vom ersten Material verschiedenen Material, welche gezielt an der Grenzfläche eine Stapelfolge BO₂/A'O aufweisen, sowie des physischen oder elektrischen Verbindens der n-Typ Übergitterstruktur und der p-Typ Übergitterstruktur.

Zudem wird ein Thermoelektrikum vorgeschlagen, welches eine Übergitterstruktur aus einer sich wiederholenden Abfolge von zwei sich voneinander unterscheidenden Materialien umfasst. Das Thermoelektrikum umfasst dabei ein erstes Material, ein zweites Material sowie ferner eine erste polare Grenzfläche an einem ersten Übergang vom ersten Material zum zweiten Material, wobei die erste polare Grenzfläche eine n-Typ-Grenzfläche oder eine p-Typ-Grenzfläche ausbildet. Ferner umfasst das Thermoelektrikum eine zweite polare Grenzfläche an einem zweiten Übergang vom zweiten Material zum ersten Material, wobei die zweite polare Grenzfläche eine n-Typ-Grenzfläche oder eine p-Typ-Grenzfläche ausbildet. Das Thermoelektrikum ist dabei als ein n-Typ-Thermoelektrikum in der Kristallrichtung ausgebildet, falls die erste Grenzfläche und die zweite Grenzfläche eine n-Typ-Grenzfläche aufweisen. Ferner ist das Thermoelektrikum als ein p-Typ-Thermoelektrikum in der Kristallrichtung ausgebildet, falls die erste Grenzfläche und die zweite Grenzfläche eine p-Typ-Grenzfläche aufweisen.

Das als n-Typ-Thermoelektrikum ausgebildete Thermoelektrikum kann eine erste Stapelfolge von Atomen aus dem ersten und zweiten Material, und das als p-Typ-Thermoelektrikum ausgebildete Thermoelektrikum kann eine zweite Stapelfolge von Atomen aus dem ersten und zweiten Material aufweisen, wobei sich die zweite Stapelfolge von der ersten Stapelfolge unterscheidet.

### Kurzbeschreibung der Figuren

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Es zeigen:
- Fig. 1: ein erfindungsgemäßes thermoelektrisches Element,
- Fig. 2: ein erfindungsgemäßes Thermoelektrikum ausgebildet als n-Typ-Thermoelektrikum;
- Fig. 3: ein erfindungsgemäßes Thermoelektrikum ausgebildet als p-Typ-Thermoelektrikum;
- Fig. 4: Seebeck-Koeffizienten und thermoelektrische Gütefaktoren für die erfindungsgemäßen Thermoelektrika;
- Fig. 5: einen erfindungsgemäßen thermoelektrischen Generator; und
- Fig. 6: ein erfindungsgemäßes Peltier-Element.

### Detaillierte Beschreibung der Erfindung

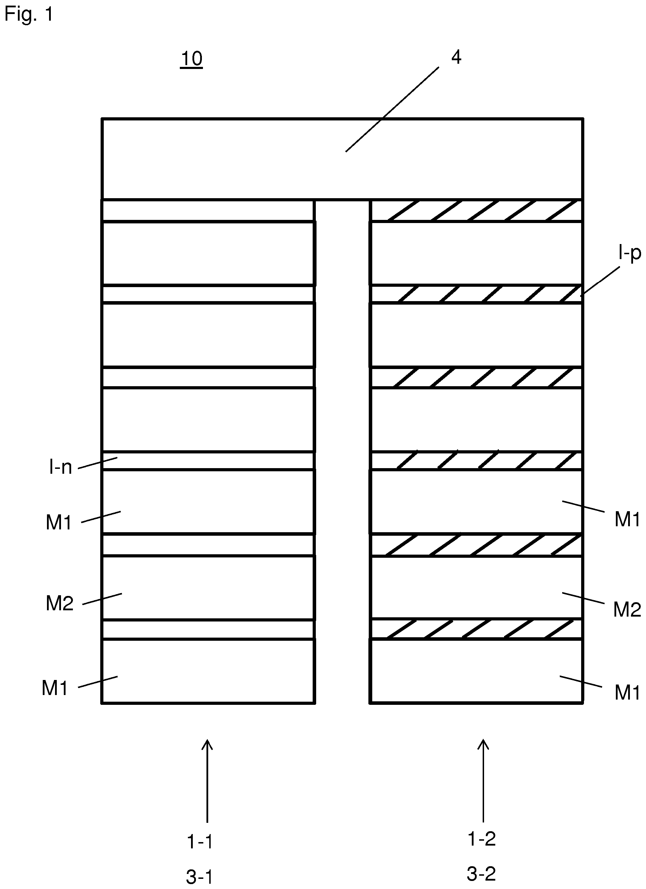

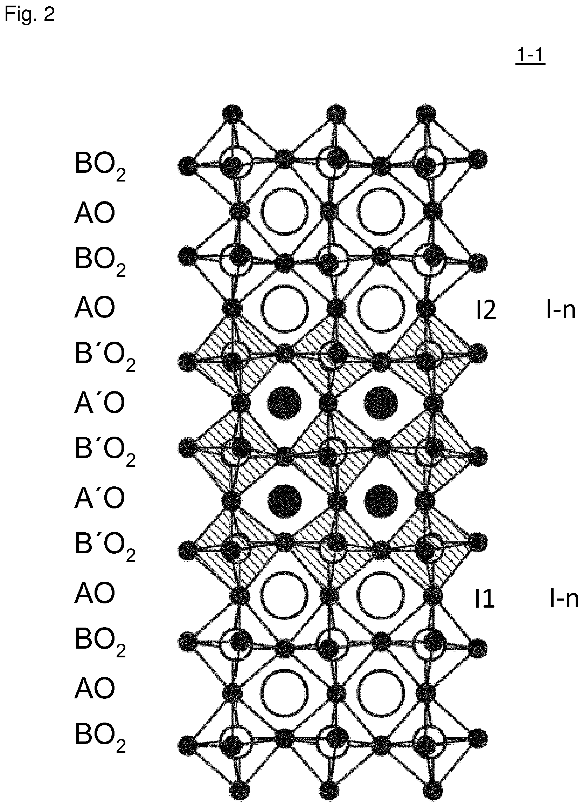

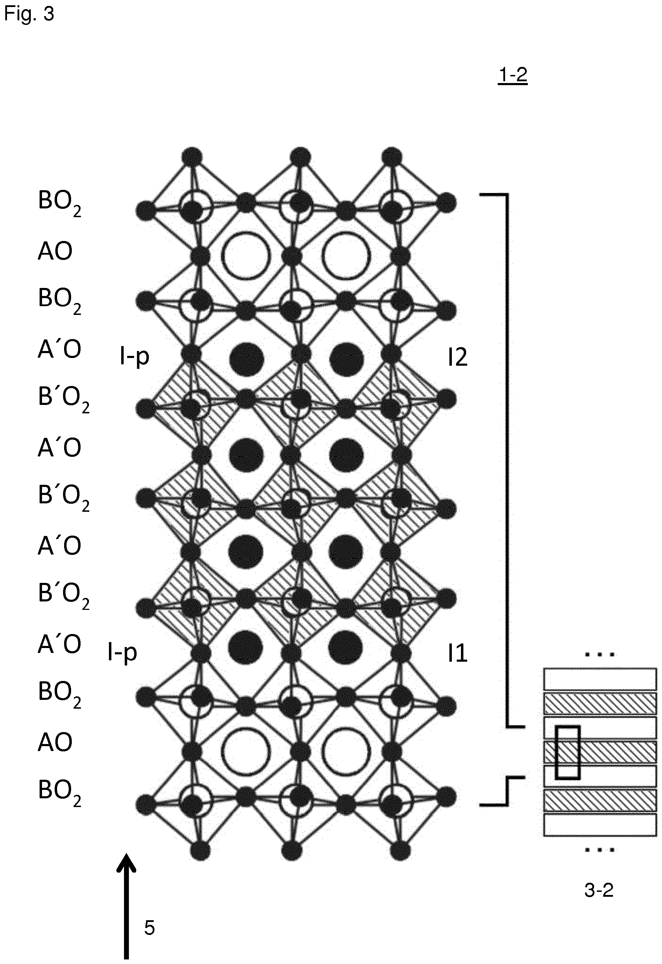

In der Figur 1 ist ein erfindungsgemäßes thermoelektrisches Element 10 dargestellt. Das thermoelektrische Element 10 umfasst dabei eine n-Typ Übergitterstruktur 3-1 und eine p-Typ Übergitterstruktur 3-2, die über eine Verbindung 4 miteinander verbunden sind. Die n-Typ Übergitterstruktur 3-1 umfasst sich abwechselnde dünne, bevorzugt nur wenige Monolagen dicke Schichten aus einem ersten Material M1 und einem davon verschiedenen, zweiten Material M2, wobei zwischen den sich abwechselnden Schichten polare Grenzflächen mit Elektronenüberschuss I-n gezielt ausgebildet sind. Eine erfindungsgemäße p-Typ Übergitterstruktur 3-2 umfasst ebenso sich abwechselnde Schichten aus dem ersten Material M1 und dem davon verschiedenen, zweiten Material M2, wobei allerdings zwischen den sich abwechselnden Schichten polaren Grenzflächen mit Lochüberschuss I-p gezielt ausgebildet sind. Eine Übergitterstruktur 3 stellt ein erfindungsgemäßes Thermoelektrikum 1 dar. Figuren 2 und 3 zeigen solche erfindungsgemäßen Thermoelektrika 1, wobei das Thermoelektrikum 1 nach Figur 2 als ein n-Typ-Thermoelektrikum 1-1 und nach Figur 3 als ein p-Typ-Thermoelektrikum 1-2 ausgebildet ist. Ein p-Typ-Thermoelektrikum 1-2 weist dabei einen positiven Seebeck-Koeffizienten auf, während ein n-Typ-Thermoelektrikum 1-1 einen negativen Seebeck-Koeffizienten aufweist. Das Thermoelektrikum 1 ist also erfindungsgemäß eine Übergitterstruktur 3, die aus in Richtung einer Kristallachse 5 übereinandergestapelten Schichten aus zwei unterschiedlichen Materialien besteht. Die Übergitterstruktur 3 umfasst demnach eine abwechselnde Abfolge von Schichten aus einem ersten Material M1 und einem zweiten Material M2, die in Richtung der Kristallachse 5 eine Stapelfolge von Atomen ausbilden. Das erste Material M1 unterscheidet sich dabei vom zweiten Material M2. Beispielsweise können dem ersten Material M1 gegenüber dem zweiten Material M2 eine gleiche Stöchiometrie aber unterschiedliche chemische Elemente zugrunde liegen.

An den Übergängen vom ersten Material M1 zum zweiten Material M2 bildet sich eine erste polare Grenzfläche I1 aus. Ferner bildet sich am Übergang vom zweiten Material M2 zum ersten Material M1 eine zweite polare Grenzfläche I2 aus. Dabei können die beiden polaren Grenzflächen I1, I2 eine n-Typ-Grenzfläche I-n oder eine p-Typ-Grenzfläche I-p ausbilden, wobei eine n-Typ-Grenzfläche I-n einen Elektronenüberschuss aufweist, also "n-dotiert" ist, und eine p-Typ-Grenzfläche I-p einen Löcherüberschuss aufweist, also "p-dotiert" ist.

Die Anzahl der Grenzflächen I1, I2 in Kristallrichtung 5 ist dabei nicht auf einen bestimmten Wert beschränkt. Es kann eine Vielzahl von Grenzflächen ausgebildet sein. Mindestens ist eine erste Grenzfläche vorhanden. Bevorzugt sind mehr als fünf Schichten übereinandergestapelt.

Für das in Figur 2 ausgeführte Thermoelektrikum 1 bildet die erste Grenzfläche I1 und die zweite Grenzfläche I2 des Thermoelektrikums 1 eine n-Typ-Grenzfläche I-n aus. In diesem Fall ist das Thermoelektrikum 1 dann als ein n-Typ-Thermoelektrikum 1-1 ausgebildet.

Das in Figur 3 ausgeführte Thermoelektrikum 1 weist als erste Grenzfläche I1 und als zweite Grenzfläche I2 des Thermoelektrikums 1 eine p-Typ-Grenzfläche I-p auf. In diesem Fall ist das Thermoelektrikum 1 als ein p-Typ-Thermoelektrikum 1-2 ausgebildet.

Wie man bei einem Vergleich der Figuren 2 und 3 sieht, unterscheiden sich die Übergitter 3 allein durch die Struktur der Grenzflächen I. Die polaren Grenzflächen mit Lochüberschuss I-p unterscheiden sich von den polaren Grenzflächen mit Elektronenüberschuss I-n am Übergang zwischen einer Schicht aus erstem Material M1 und zweitem Material M2 durch die gezielt beeinflussbare und ausgewählte Stapelfolge der Atome an der Grenzfläche I. Es kann allein durch die Stapelfolge der Atome am Übergang zwischen erster und zweiter Schicht eingestellt werden, ob es sich um ein n-Typ oder ein p-Typ Thermoelektrikum 1 handelt. Die polaren Grenzflächen mit Lochüberschuss I-p unterscheiden sich also von den polaren Grenzflächen mit Elektronenüberschuss I-n am Übergang zwischen einer Schicht aus erstem Material M1 und zweitem Material M2 dadurch, dass die Schichten aus dem ersten Material M1 gezielt mit positiver Polarität oder mit negativer Polarität ausgebildet sind.

Somit kann aus einem Thermoelektrikum 1 mit Übergitterstruktur 3 und polaren Grenzflächen I1, I2 mittels Variation der Polaritäten zwischen zwei Zuständen, einem Zustand als n-Typ-Thermoelektrikum 1-1 und einem Zustand als p-Typ-Thermoelektrikum 1-2, gezielt durch entsprechende Terminierung der Schichten gewechselt werden. Dadurch, dass sich die beiden Ausbildungen des Thermoelektrikums 1 lediglich in den Grenzflächen I1, I2 unterscheiden, weisen das n-Typ-Thermoelektrikum 1-1 und das p-Typ-Thermoelektrikum 1-2 vorteilhaft eine strukturell und elektronisch hohe Kompatibilität auf.

Als Materialien M1, M2 für das erste Material M1 und das zweite Material M2 werden in einem Ausführungsbeispiel jeweils oxidbasierte Materialien M1, M2 verwendet. Der Vorteil von oxidischen Materialien gegenüber beispielsweise dotierten Halbleitern liegt dabei unter anderem in der thermischen Stabilität. Ferner können oxidische Materialien mit aktuellen technischen Verfahren auf atomarer Längenskala mit scharfen, wohldefinierten Grenzflächen gewachsen und miteinander kombiniert werden. Grundsätzlich können aber zum Beispiel auch nichtoxidische Halbleiter Anwendung finden, die entsprechende polare Grenzflächen I-p, I-n ausbilden und deren thermoelektrische Antwortkoeffizienten bei Wechsel der Polaritäten an den polaren Grenzflächen I-n, I-p ebenfalls das Vorzeichen wechseln.

Das erste und das zweite Material können in einem bevorzugten Ausführungsbeispiel der chemischen Formel ABO₃ bzw. A'B'O₃ folgen. Die polare Grenzfläche mit Elektronenüberschuss ist dann eine (AO)⁺/(B'O₂)⁰ Grenzfläche und die polare Grenzfläche mit Lochüberschuss eine (A'O)⁰/(BO₂)⁻ Grenzfläche. Diese können gezielt während des Wachstums der Kristallschichten ausgewählt werden und somit kann gezielt eine n-Typ oder eine p-Typ Übergitterstruktur 3 ausgebildet werden.

In dem hier ausgeführten Beispiel werden Übergangsmetalloxide mit der chemischen Formel ABO₃ in der Perowskit-Struktur für das erste oxidbasierte Material M1 verwendet. Für das zweite oxidbasierte Material M2 wird ebenfalls ein Übergangsmetalloxid mit der chemischen Formel A'B'O₃ in der Perowskit-Struktur vorliegend verwendet. Als Kristallrichtung 5, die die Stapelrichtung des Übergitters 3 definiert, wird in dem gezeigten aber nicht beschränkenden Ausführungsbeispiel die [001]-Kristallrichtung verwendet. Die Perowskit-Strukturen sind dabei quasikubisch und es bilden sich in [001]-Kristallrichtung quasi-zweidimensionale Schichten aus, die je nach Wahl der chemischen Elemente mit unterschiedlicher Ladung geladen sind. Die Erfindung ist aber nicht auf Perowskit-Strukturen beschränkt.

Als konkrete Ausführung wird hierbei A=La und B=Ni und A'=Sr und B'=Ti gesetzt, so dass sich ein Übergitter 3 der Form LaNiO₃/SrTiO₃ ausbildet, wobei das erste Material M1 demnach LaNiO₃ und das zweite Material M2 SrTiO₃ entspricht. Innerhalb des zum Material M2 befindlichen Abschnitts des Übergitters 3, liegen in [001]-Kristallrichtung abwechselnde Schichten aus (SrO)⁰ und (TiO₂)⁰ vor, die formell ladungsneutral sind. Im Bereich des Materials M1 wechseln sich polare Schichten aus (LaO)⁺ und (NiO₂)⁻ ab.

Im Falle des in Figur 2 dargestellten Thermoelektrikums 1 als n-Typ-Thermoelektrikum 1-1 sind sowohl die erste polare Grenzfläche I1 als auch die zweite polare Grenzfläche I2 als n-Typ-Grenzfläche I-n ausgebildet, die in dem hier ausgeführten und nicht beschränkenden Fall durch (LaO)⁺/(TiO₂)⁰ gebildet werden. Im Falle des in Figur 3 dargestellten Thermoelektrikums 1 als p-Typ-Thermoelektrikum 1-2 sind sowohl die erste polare Grenzfläche I1 als auch die zweite polare Grenzfläche I2 als p-Typ-Grenzfläche I-p ausgebildet, die in dem hier ausgeführten und nicht beschränkenden Beispiel durch (NiO₂)⁻/SrO⁰ gebildet werden. An diesen polaren Grenzflächen I1, I2 bildet sich eine räumlich beschränkte elektrostatische Dotierung aus, auch δ-Dotierung genannt. Für die polare Grenzfläche (LaO)⁺/(TiO₂)⁰ liegt dabei eine n-Dotierung (Elektron-Dotierung) von - e/2 vor und für die polare Grenzfläche (NiO₂)⁻/(SrO)⁰ liegt eine p-Dotierung (Loch-Dotierung) von +e/2 vor.

Die Stapelfolgen des Thermoelektrikums 1 können stöchiometrisch durch (LaNiO₃)_{M}/(SrTiO₃)_{N} dargestellt werden. Im Falle des als n-Typ-Thermoelektrikums ausgebildeten Thermoelektrikums 1 ist hierbei M=3,5 und N=2,5 gewählt, während im Falle der Ausbildung des Thermoelektrikums 1 als p-Typ-Thermoelektrikum entsprechend stöchiometrisch M=2,5 und N=3,5 gewählt ist, wobei sich damit die oben beschriebenen polaren Grenzflächen I1, I2 jeweils ausbilden. Die Erfindung ist hierbei jedoch nicht auf diese Festlegungen bezüglich der Stöchiometrie beschränkt.

Die konkrete Materialwahl für das Oxid in Form des LaNiO₃/SrTiO₃ ist hierbei nur beispielhaft ausgeführt. Die Erfindung ist nicht auf diese speziellen Oxide beschränkt. Eine große Anzahl ähnlicher Oxide bietet hierbei weiteren Spielraum für Optimierungen des thermoelektrischen Verhaltens.

Figur 4 zeigt quantitative Resultate für den thermoelektrischen Antwortkoeffizienten (Seebeck-Koeffizienten) sowie die thermoelektrische Effektivität, auch Gütefaktor genannt, als Funktion der Temperatur. In der linken Spalte der Figur 4 werden der thermoelektrische Antwortkoeffizient (Seebeck-Koeffizient) und der Gütefaktor für das in Figur 2 beschriebene als n-Typ-Thermoelektrikum 1-1 ausgebildete Thermoelektrikum 1 gezeigt, wobei beispielhaft als Richtung die [001]-Kristallrichtung 5 gewählt ist. Dabei ist entsprechend der thermoelektrische Antwortkoeffizient (Seebeck-Koeffizient) negativ für alle Temperaturen, was somit einem n-Typ-Thermoelektrikum entspricht. Bei Zimmertemperatur ergibt sich ein Wert für den Seebeck-Koeffizienten von etwa -20 µV/K bei einem Gütefaktor von etwa 0,05. Der Seebeck-Koeffizient bzw. der Gütefaktor kann bei Bedarf zusätzlich mit Hilfe von Dotierung durch Fremdatome weiter optimiert und verbessert werden. Wesentlich ist jedoch, dass sich die Grenzflächen durch die Stapelfolge der Atome an der Grenzfläche unterscheiden und eine Dotierung dann nur zusätzlich zu dieser veränderten Stapelfolge zum Einsatz kommt. Ein entsprechender Verlauf des Seebeck-Koeffizientens eines so behandelten Thermoelektrikums ist in Fig. 4 als gestrichelte Linie gezeigt.

In der rechten Spalte der Figur 4 werden der thermoelektrische Antwortkoeffizient (Seebeck-Koeffizient) und der Gütefaktor für das in Figur 3 beschriebene als p-Typ-Thermoelektrikum 1-2 ausgebildete Thermoelektrikum 1 gezeigt, wobei als Richtung die [001]-Kristallrichtung 5 gewählt ist. Entsprechend ist der thermoelektrische Antwortkoeffizient (Seebeck-Koeffizient) positiv für alle Temperaturen, was somit einem p-Typ-Thermoelektrikum entspricht. Bei Zimmertemperatur ergibt sich ein Wert für den Seebeck-Koeffizienten von etwa 135 µV/K bei einem Gütefaktor von etwa 0,35.

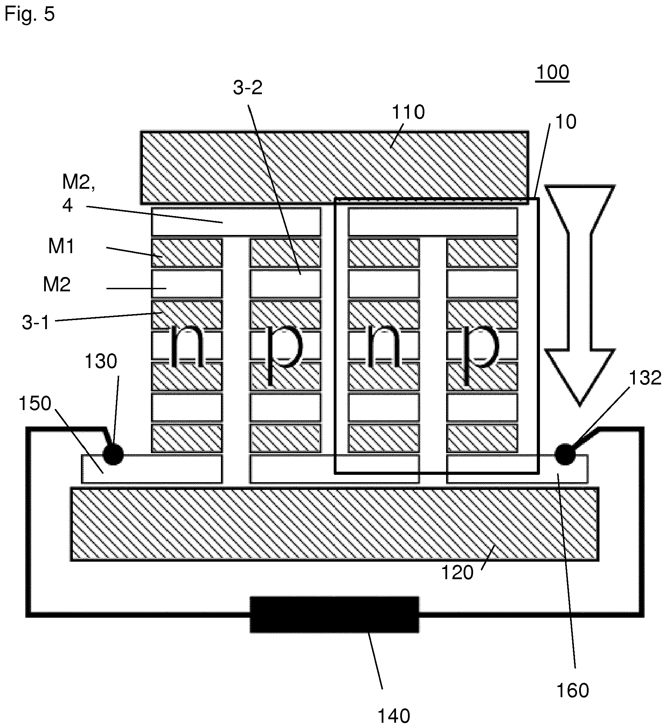

Somit ermöglichen die beiden als n-Typ-Thermoelektrikum und als p-Typ-Thermoelektrikum ausgebildeten Thermoelektrika 1 die Konstruktion eines oxidbasierten thermoelektrischen Generators, siehe dazu die folgende Figur 5. Da dabei keine unterschiedlichen Materialien verwendet werden, sondern lediglich die polaren Grenzflächen I1, I2 unterschiedlich ausgebildet sind, nämlich als n-Typ-Grenzflächen einerseits bzw. als p-Typ-Grenzflächen andererseits, können somit strukturelle und elektronische Kompatibilitätsprobleme, wie sie bei zwei unterschiedlichen Materialien häufig auftreten, vermieden werden. Ferner werden ungewünschte Migrations- und Segregationseffekte, wie sie bei dotierten Halbleitermaterialien bei hohen Temperaturen mit der Folge der Auslöschung der Wirkung auftreten, vermieden. Ferner wird die Dotierung von Halbleitern, die stets statistischer Natur ist, vorteilhaft nicht benötigt.

Figur 5 zeigt einen thermoelektrischen Generator 100. Der thermoelektrische Generator 100 umfasst dabei eine Wärmequelle 110 und eine Wärmesenke 120. Der thermoelektrische Generator 100 ist aus mehreren in Reihe geschalteten thermoelektrischen Elementen 10 der Figur 1 gebildet. Die Reihenschaltung erfolgt dadurch, dass jeweils eine untere und eine obere Schicht der Übergitterstrukturen 3 sich über zwei benachbarte Übergitterstrukturen 3 erstreckt und eine Verbindung 4 ausbildet (beispielsweise bestehend aus Material M1). Diese oben und unten abschließenden, die Verbindung 4 ausbildenden Schichten stehen im thermischen Kontakt mit der Wärmequelle 110 und der Wärmesenke 120.

Durch die unterschiedlichen Temperaturen der Wärmequelle 110 und der Wärmesenke 120 entsteht zwischen der Wärmequelle 110 und der Wärmesenke 120 ein Temperaturgradient, der durch den Pfeil in Figur 5 dargestellt ist. Dieser Gradient liegt an gegenüberliegenden Enden der Übergitterstrukturen 3 an. Die Übergitterstrukturen 3 bilden eine Folge aus p-Typ-Thermoelektrika 1-2 mit p-Typ-Grenzflächen I-p und n-Typ-Thermoelektrika 1-1 mit n-Typ-Grenzflächen I-n, alternierend ausgebildet. Dabei weist jedes p-Typ-Thermoelektrikum 1-2 bzw. jedes n-Typ-Thermoelektrikum 1-1 rein beispielhaft und nicht beschränkend acht p-Typ-Grenzflächen I-p bzw. n-Typ-Grenzflächen I-n auf, wobei die Erfindung nicht auf eine bestimmte Anzahl von Grenzflächen beschränkt ist.

Ferner werden elektrische Kontakte 130, 132 zum Abgreifen einer elektrischen Spannung, die als Folge des thermoelektrischen Effekts bei Anlegen eines Temperaturgefälles entsteht, an einem ersten Ende 150 der Reihenschaltung der thermoelektrischen Elemente 10 und an einem zweiten Ende 160 beigefügt. In der vorliegenden Figur ist ferner eine Last 140 an die beiden Kontakte 130, 132 als Verbraucher angeschlossen, wobei die Last 140 die erzeugte thermoelektrische Spannung nutzt.

Figur 6 zeigt ähnlich zu Figur 5 ein Peltier-Element 200, wobei hierbei das Prinzip des in Figur 5 beschriebenen thermoelektrischen Generators 100 umgekehrt wird. Das Peltier-Element 200 umfasst dabei wiederum in Reihe geschaltete Folgen von Thermoelektrika 1, wobei sich p-Typ-Thermoelektrika 1-2 und n-Typ-Thermoelektrika 1-1 abwechseln. Das Peltier-Element 200 umfasst somit mehrere in Reihe geschaltete thermoelektrische Elemente 10 der Figur 1.

Im Gegensatz zur Figur 5 liegt jetzt kein Temperaturgradient an, sondern es wird eine Spannung über eine Spannungsquelle 240 an die Kontakte 230, 232 des Peltier-Elementes 200 angelegt. Bei Anschluss der Spannung wird dabei der Kühlkontakt bzw. die Wärmesenke 210 gekühlt, während der Heizkontakt bzw. die Wärmequelle 220 durch Umkehrung des thermoelektrischen Effekts erwärmt wird. Der zugeführte elektrische Strom durchfließt alle Übergitterstrukturen 3 nacheinander. Abhängig von Stromstärke und -richtung kühlen sich die unteren Verbindungsstellen ab, während die oberen sich erwärmen. Der Strom pumpt somit Wärme von einer Seite auf die andere und erzeugt eine Temperaturdifferenz.

Der thermoelektrische Generator 100 und das beschriebene Peltier-Element 200 weisen vorteilhaft p-Typ-Thermoelektrika und n-Typ-Thermoelektrika mit hoher elektronischer und struktureller Kompatibilität auf, da diese sich lediglich durch die Polarität des Grenzflächentyps, nämlich einerseits zwei Elektron-dotierte n-Typ-Grenzflächen und anderseits zwei Loch-dotierte p-Typ-Grenzflächen, unterscheiden. Ferner werden ungewünschte Migrations- und Segregationseffekte, wie sie bei dotierten Halbleitermaterialien bei hohen Temperaturen mit der Folge der Auslöschung der Wirkung auftreten, vermieden. Ferner wird die Dotierung von Halbleitern, die stets statistischer Natur ist, vorteilhaft nicht benötigt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 1: Thermoelektrikum
- 1-1: n-Typ Thermoelektrikum
- 1-2: p-Typ Thermoelektrikum
- 3: Übergitterstruktur
- 3-1: n-Typ Übergitterstruktur
- 3-2: p-Typ Übergitterstruktur
- 4: Verbindung zwischen Übergitterstrukturen
- 5: Kristallrichtung
- 10: thermoelektrisches Element
- 100: thermoelektrischer Generator
- 110: Wärmequelle
- 120: Wärmesenke
- 130: erster elektrischer Kontakt
- 132: zweiter elektrischer Kontakt
- 140: Last
- 200: Peltier-Element
- 210: Wärmequelle
- 220: Wärmesenke
- 230, 232: elektrische Kontakte
- 240: Spannungsquelle

- M1: erstes Material
- M2: zweites Material
- I: Grenzfläche
- I-p: p-Typ Grenzfläche
- I-n: n-Typ Grenzfläche

## Patentansprüche

1. Thermoelektrisches Element (10) umfassend:
eine n-Typ Übergitterstruktur (3-1) umfassend sich abwechselnde Schichten aus einem ersten Material (M1) und einem davon verschiedenen, zweiten Material (M2), wobei zwischen den sich jeweils abwechselnden Schichten polare Grenzflächen (I-n) mit Elektronenüberschuss ausgebildet sind,
eine p-Typ Übergitterstruktur (3-2) umfassend sich abwechselnde Schichten aus dem ersten Material (M1) und dem davon verschiedenen, zweiten Material (M2), wobei zwischen den sich jeweils abwechselnden Schichten polare Grenzflächen (I-p) mit Lochüberschuss ausgebildet sind,
wobei die n-Typ Übergitterstruktur (3-1) und die p-Typ Übergitterstruktur (3-2) eine Verbindung (4) aufweisen und
wobei sich die polaren Grenzflächen mit Lochüberschuss von den polaren Grenzflächen mit Elektronenüberschuss durch die Terminierung der Schichten aus erstem Material (M1) und zweitem Material (M2) an den Grenzflächen unterscheiden.

2. Thermoelektrisches Element (10) nach Anspruch 1, wobei mindestens eines der beiden ersten und zweiten Materialien (M1, M2) ein Isolator, bevorzugt ein oxidbasierter Isolator ist.

3. Thermoelektrisches Element (10) nach einem der vorhergehenden Ansprüche, wobei eines der beiden ersten und zweiten Materialien (M1, M2) ein oxidbasiertes Metall oder ein oxidbasierter Isolator und das andere der beiden ersten und zweiten Materialien (M1, M2) ein oxidbasierter Isolator ist.

4. Thermoelektrisches Element (10) nach Anspruch 3, wobei das erste und das zweite Material (M1, M2) jeweils eine Perowskit-Struktur aufweisen.

5. Thermoelektrisches Element (10) nach Anspruch 3 oder 4, wobei das erste Material (M1) einer chemischen Formel ABO₃ folgt und das zweite Material (M2) einer chemischen Formel A'B'O₃ folgt.

6. Thermoelektrisches Element (10) nach Anspruch 5, wobei die Grenzfläche mit negativer Polarität (I-n) eine (AO)⁺/(B'O₂)⁰ Grenzfläche ist und die Grenzfläche mit positiver Polarität (I-p) eine (A'O)⁰/(BO₂)⁻ Grenzfläche ist.

7. Thermoelektrisches Element (10) nach einem der vorhergehenden Ansprüche, wobei das erste Material (M1) LaNiO₃ und das zweite Material (M2) SrTiO₃ ist.

8. Thermoelektrisches Element (10) nach Anspruch 7, wobei die n-Typ Grenzfläche (In) die Abfolge (LaO)⁺/(TiO₂)⁰ aufweist und die p-Typ Grenzfläche (I-p) die Abfolge (NiO₂)⁻/(SrO)⁰ aufweist.

9. Thermoelektrisches Element (10) nach Anspruch 1, wobei das erste Material (M1) ein erster nicht-oxidischer Halbleiter und das zweite Material (M2) ein zweiter nicht-oxidischer Halbleiter ist.

10. Thermoelektrischer Generator (100) umfassend:
eine Wärmequelle (110),
eine Wärmesenke (120), und
ein zwischen Wärmequelle (110) und Wärmesenke (120) angeordnetes thermoelektrisches Element (10) nach einem der Ansprüche 1 bis 9, wobei das thermoelektrisches Element (10) zwei Kontakte (130, 132) zum Anschließen einer Last (140) aufweist.

11. Thermoelektrischer Generator (100) nach Anspruch 10, wobei jeweils eine erste Seite der n-Typ Übergitterstruktur (3-1) und der p-Typ Übergitterstruktur (3-2) mit der Wärmequelle (110) verbunden ist und eine gegenüberliegende Seite der n-Typ Übergitterstruktur (3-1) und der p-Typ Übergitterstruktur (3-2) mit der Wärmesenke (120) verbunden ist.

12. Thermoelektrischer Generator (100) nach Anspruch 10 oder 11, wobei weitere thermoelektrische Elemente (10) zwischen Wärmequelle (110) und Wärmesenke (120) in alternierender Reihenschaltung angeordnet sind.

13. Peltier-Element (200) umfassend:
eine Wärmequelle (210),
eine Wärmesenke (220), und
ein zwischen Wärmequelle (210) und Wärmesenke (220) angeordnetes thermoelektrisches Element (10) nach einem der Ansprüche 1 bis 9, wobei das thermoelektrische Element (10) zwei Kontakte (230, 232) zum Anschließen einer Energiequelle (240) aufweist.

14. Verfahren zur Herstellung von thermoelektrischen Elementen (10) umfassend:
Ausbilden einer n-Typ Übergitterstruktur (3-1) durch alternierendes Stapeln von Schichten aus einem ersten Material (M1), und Schichten aus einem zweiten, vom ersten Material verschiedenen Material (M2) mit dazwischenliegenden polaren Grenzflächen (I-n) mit Elektronenüberschuss;
Ausbilden einer p-Typ Übergitterstruktur (3-2) durch alternierendes Stapeln von Schichten aus einem ersten Material (M1) und Schichten aus einem zweiten, vom ersten Material verschiedenen Material (M2) mit dazwischenliegenden polaren Grenzflächen (I-p) mit Lochüberschuss;
Verbinden der n-Typ Übergitterstruktur (3-1) und der p-Typ Übergitterstruktur (3-2),
wobei sich die polaren Grenzflächen mit Lochüberschuss von den polaren Grenzflächen mit Elektronenüberschuss am Übergang zwischen einer Schicht aus erstem Material (M1) und zweitem Material (M2) durch die Stapelfolge der Atome aus erstem bzw. zweitem Material (M1, M2) an der Grenzfläche unterscheiden.

## Claims

1. A thermoelectric element (10) comprising:
an n-type superlattice structure (3-1) comprising alternating layers of a first material (M1) and a second material (M2) other than said first material, wherein polar interfaces (I-n) with an excess of electrons are formed between said alternating layers in each case,
a p-type superlattice structure (3-2) comprising alternating layers of the first material (M1) and the second material (M2) other than said first material, wherein polar interfaces (I-p) with an excess of holes are formed between said alternating layers in each case,
wherein the n-type superlattice structure (3-1) and the p-type superlattice structure (3-2) have a connection (4), and
wherein the polar interfaces with an excess of holes differ from the polar interfaces with an excess of electrons by the termination of said layers of the first material (M1) and the second material (M2) at said interfaces.

2. The thermoelectric element (10) according to Claim 1, wherein at least one of the two first and second materials (M1, M2) is an insulator, preferably an oxide-based insulator.

3. The thermoelectric element (10) according to any one of the preceding claims, wherein one of the two first and second materials (M1, M2) is an oxide-based metal or an oxide-based insulator and the other of the two first and second materials (M1, M2) is an oxide-based insulator.

4. The thermoelectric element (10) according to Claim 3, wherein the first and the second material (M1, M2) each have a perovskite structure.

5. The thermoelectric element (10) according to Claim 3 or 4, wherein the first material (M1) follows a chemical formula ABO₃ and the second material (M2) follows a chemical formula A'B'O₃.

6. The thermoelectric element (10) according to Claim 5, wherein the interface with a negative polarity (I-n) is an (AO)⁺/(B'O₂)⁰ interface and the interface with a positive polarity (I-p) is an (A'O)⁰/(BO₂)⁻ interface.

7. The thermoelectric element (10) according to any one of the preceding claims, wherein the first material (M1) is LaNiO₃ and the second material (M2) is SrTiO₃.

8. The thermoelectric element (10) according to Claim 7, wherein the n-type interface (I-n) has the sequence (LaO)⁺/(TiO₂)⁰ and the p-type interface (I-p) has the sequence (NiO₂)⁻/(SrO)⁰.

9. The thermoelectric element (10) according to Claim 1, wherein the first material (M1) is a first non-oxidic semiconductor and the second material (M2) is a second non-oxidic semiconductor.

10. A thermoelectric generator (100) comprising:
a heat source (110),
a heat sink (120), and
a thermoelectric element (10) according to any one of Claims 1 to 9 arranged between said heat source (110) and said heat sink (120), wherein the thermoelectric element (10) has two contacts (130, 132) for connecting a load (140).

11. The thermoelectric generator (100) according to Claim 10, wherein a first side of the n-type superlattice structure (3-1) and of the p-type superlattice structure (3-2) is connected to the heat source (110) in each case and an opposite side of the n-type superlattice structure (3-1) and of the p-type superlattice structure (3-2) is connected to the heat sink (120).

12. The thermoelectric generator (100) according to Claim 10 or 11, wherein further thermoelectric elements (10) are arranged between the heat source (110) and the heat sink (120) in an alternating series connection.

13. A Peltier element (200) comprising:
a heat source (210),
a heat sink (220), and
a thermoelectric element (10) according to any one of Claims 1 to 9 arranged between said heat source (210) and said heat sink (220), wherein the thermoelectric element (10) has two contacts (230, 232) for connecting an energy source (240).

14. A method for producing thermoelectric elements (10), comprising:
forming an n-type superlattice structure (3-1) by alternatingly stacking layers of a first material (M1) and layers of a second material (M2) other than said first material with polar interfaces (I-n) with an excess of electrons therebetween;
forming a p-type superlattice structure (3-2) by alternatingly stacking layers of a first material (M1) and layers of a second material (M2) other than said first material with polar interfaces (I-p) with an excess of holes therebetween;
connecting the n-type superlattice structure (3-1) and the p-type superlattice structure (3-2),
wherein the polar interfaces with an excess of holes differ from the polar interfaces with an excess of electrons at the transition between a layer of the first material (M1) and a second material (M2) by the stacking sequence of the atoms of said first and second materials (M1, M2) at the interface.

## Revendications

1. Élément thermoélectrique (10) comprenant :
une structure de support-réseau (3-1) de type n comprenant des couches alternées composées d'un premier matériau (M1) et d'un deuxième matériau (M2) différent de celui-ci, des interfaces polaires (I-n) avec surplus d'électrons étant formées entre les couches respectivement alternées,
une structure de support-réseau (3-2) de type p comprenant des couches alternées composées d'un premier matériau (M1) et du deuxième matériau (M2) différent de celui-ci, des interfaces polaires (I-n) avec surplus de trous étant formées entre les couches respectivement alternées,
le super-réseau (3-1) de type n et le super-réseau (3-2) de type p présentant une liaison (4) et
les interfaces polaires avec surplus de trous se distinguant des interfaces polaires avec surplus d'électrons par la terminaison des couches composées du premier matériau (M1) et du deuxième matériau (M2), aux interfaces.

2. Élément thermoélectrique (10) selon la revendication 1, au moins un matériau parmi le premier et le deuxième matériaux (M1, M2) étant un isolateur, de préférence un isolateur à base d'oxyde.

3. Élément thermoélectrique (10) selon l'une quelconque des revendications précédentes, l'un des matériaux parmi le premier et le deuxième matériaux (M1, M2) étant un métal à base d'oxyde ou un isolateur à base d'oxyde, et l'autre matériau parmi le premier et le deuxième matériaux (M1, M2) étant un isolateur à base d'oxyde.

4. Élément thermoélectrique (10) selon la revendication 3, les premier et deuxième matériaux (M1, M2) présentant respectivement une structure pérovskite.

5. Élément thermoélectrique (10) selon la revendication 3 ou 4, le premier matériau (M1) ayant une formule chimique ABO₃ et le deuxième matériau (M2) ayant une formule chimique A'B'O₃.

6. Élément thermoélectrique (10) selon la revendication 5, l'interface avec polarité négative (I-n) étant une interface (AO)⁺/(B'O₂)⁰ et l'interface avec polarité positive (I-p) étant une interface (A'O)⁰/(BO₂)⁻.

7. Élément thermoélectrique (10) selon l'une quelconque des revendications précédentes, le premier matériau (M1) étant LaNiO₃ et le deuxième matériau (M2) étant SrTiO₃.

8. Élément thermoélectrique (10) selon la revendication 7, l'interface (I-n) de type n présentant la séquence (LaO)⁺/(TiO₂)⁰ et l'interface (I-p) de type p présentant la séquence (NiO₂)⁻/(SrO)⁰.

9. Élément thermoélectrique (10) selon la revendication 1, le premier matériau (1) étant un premier semi-conducteur non oxydique et le deuxième matériau (M2) étant un deuxième semi-conducteur non oxydique.

10. Générateur thermoélectrique (100) comprenant :
une source de chaleur (110),
un puits thermique (120), et
un élément thermoélectrique (10) selon l'une des revendications 1 à 9 disposé entre la source de chaleur (110) et le puits thermique (120), l'élément thermoélectrique (10) présentant deux contacts (130, 132) pour la connexion d'une charge (140).

11. Générateur thermoélectrique (100) selon la revendication 10, un premier côté, respectivement, du super-réseau (3-1) de type n et du super-réseau (3-2) de type p étant relié à la source de chaleur (110), et un côté opposé du super-réseau (3-1) de type n et du super-réseau (3-2) de type p étant relié au puits thermique (120).

12. Générateur thermoélectrique (100) selon la revendication 10 ou 11, d'autres éléments thermoélectriques (10) étant disposés entre la source de chaleur (110) et le puits thermique (120) par montage en série alterné.

13. Élément Peltier (200) comprenant :
une source de chaleur (210),
un puits thermique (220), et
un élément thermoélectrique (10) selon l'une des revendications 1 à 9 disposé entre la source de chaleur (210) et le puits thermique (220), l'élément thermoélectrique (10) présentant deux contacts (230, 232) pour la connexion d'une source d'énergie (240).

14. Procédé pour la fabrication d'éléments thermoélectriques (10) comprenant :
formation d'un super-réseau (3-1) de type n par empilement alterné de couches composées d'un premier matériau (M1), et de couches composées d'un deuxième matériau (M2) différent du premier matériau avec interfaces polaires (I-n) intermédiaires avec surplus d'électrons ;
formation d'un super-réseau (3-2) de type p par empilement alterné de couches composées d'un premier matériau (M1) et de couches composées d'un deuxième matériau (M2) différent du premier matériau avec interfaces polaires (I-p) intermédiaires avec surplus de trous ;
liaison du super-réseau (3-1) de type n et du super-réseau (3-2) de type p,
les interfaces polaires avec surplus de trous se distinguant des interfaces polaires avec surplus d'électrons au niveau du passage entre une couche du premier matériau (M1) et du deuxième matériau (M2) par l'ordre d'empilement des atomes du premier ou du deuxième matériau (M1, M2) aux interfaces.
